# DEMANDE DE BREVET EUROPEEN

(11) **EP 0 572 294 A1**
(43) Date de publication de la demande: **01.12.1993**
(21) Numéro de dépôt: 93401181.8
(22) Date de dépôt: 07.05.1993
(51) Int. Cl.: H03M 1/14

(54) **Dispositif de limitation de signaux d'entrée d'un convertisseur analogique-numérique**

(30) Priorité: 26.05.1992 FR 9206433
(71) Demandeur: THOMSON-CSF, 75008 Paris (FR)
(72) Inventeur: Maclman, Serge, F-92402 Courvoie Cedex (FR); Carl, Olivier, F-92402 Courvoie Cedex (FR)
(74) Mandataire: Benoit, Monique

(57) **Abrégé**

L'invention se rapporte à un dispositif de limitation de signaux d'entrée d'un convertisseur analogique-numérique.

Le dispositif comprend en entrée (E) un convertisseur analogique-numérique auxiliaire (2) dont la sortie est reliée à l'entrée d'un convertisseur numérique-analogique (3). La sortie de ce dernier est reliée à l'entrée négative d'un circuit soustracteur (4). Un circuit à retard (5) est câblé entre l'entrée du convertisseur analogique-numérique auxiliaire (2) et l'entrée négative du circuit soustracteur (4). La sortie de ce dernier constitue la sortie du dispositif.

Application : limitation de la tension d'entrée de convertisseurs analogique-numériques dans des chaînes de réception d'un radar.

## Description

La présente invention concerne un dispositif de limitation de signaux d'entrée d'un convertisseur analogique-numérique.

Elle s'applique notamment à la conversion numérique des signaux reçus par une chaîne de réception radar en supprimant ainsi l'utilisation de circuits de limitation classiques. Plus généralement, elle s'applique aux systèmes de conversion analogique-numérique dont les signaux d'entrée ont une amplitude qui sort des limites de la plage de conversion, de façon intermittente par exemple, sans qu'il soit possible de les comprimer préalablement.

Une solution simple pour rendre compatibles les signaux d'entrée de systèmes de conversion analogique-numérique avec la plage de conversion de ces derniers et éviter ainsi leur destruction, consiste à diminuer leur amplitude en les comprimant ou en les transposant éventuellement. Cependant, lorsque l'ensemble des signaux à convertir présente une grande dynamique d'amplitude, la compression s'exerçant de la même façon indifféremment sur les signaux forts et les signaux faibles, il s'ensuit que ces derniers, trop comprimés, ne peuvent généralement plus être convertis de façon fiable.

En particulier, dans le cas des signaux reçus par des radars, le bruit accompagnant ces signaux, notamment dû à des échos fixes, empêche de trop les comprimer. Des circuits de limitation écrêtent ces signaux quand leur amplitude dépasse les limites de la plage de conversion des convertisseurs analogique-numérique. Cependant, ces circuits de limitation présentent plusieurs inconvénients.

Un premier inconvénient provient du fait de la détérioration de la linéarité de ces circuits de limitation quand l'amplitude des signaux qu'ils laissent passer se rapproche du seuil de limitation. Dans le cas d'une chaîne de réception radar par exemple, cela affecte de façon dommageable la linéarité de la chaîne de réception.

D'autres inconvénients proviennent aussi du fait que ces circuits de limitation sont généralement réalisés à base de diodes. En conséquence, ils nécessitent un réglage délicat, diminuant la fiabilité et augmentant notamment les coûts de mise en oeuvre, présentant une sensibilité importante à la température et aux variations de tension d'alimentation notamment. Enfin, leur durée de vie reste encore limitée. Pour éviter la compression ou la limitation des signaux à convertir il est possible d'étendre la plage de conversion des convertisseurs en câblant plusieurs en série ou en parallèle, néanmoins cette solution est coûteuse, peu fiable, et encombrante à cause de l'augmentation du nombre de convertisseurs et des grandes précautions de câblage qu'elle nécessite.

Le but de l'invention est de pallier les inconvénients précités en permettant notamment de conserver à la limitation une linéarité sur toute la plage de conversion des convertisseurs.

A cet effet, l'invention a pour objet un dispositif de limitation de signaux d'entrée d'un convertisseur analogique-numérique, caractérisé en ce qu'il comprend au moins:
- un convertisseur analogique-numérique auxiliaire
- un convertisseur numérique-analogique dont l'entrée est reliée à la sortie du convertisseur analogique-numérique auxiliaire ;
- un circuit à retard dont l'entrée est reliée à l'entrée du convertisseur analogique-numérique auxiliaire et constitue l'entrée du dispositif;
- un circuit soustracteur présentant à sa sortie le signal arrivant sur une première entrée diminué du signal arrivant sur une deuxième entrée, la première entrée étant reliée à la sortie du circuit à retard et la deuxième entrée étant reliée à la sortie du convertisseur numérique-analogique, la sortie du circuit soustracteur constituant la sortie du dispositif,

le bit de poids faible du convertisseur analogique-numérique auxiliaire codant la valeur de la tension délimitant la plage de conversion analogique-numérique.

Outre le fait qu'elle conserve la linéarité, l'invention a pour principaux avantages qu'elle permet d'étendre la plage de conversion de convertisseurs analogique-numérique, qu'elle est peu sensible aux conditions d'environnement, qu'elle ne nécessite pas de réglage délicat, enfin qu'elle est simple à mettre en oeuvre, qu'elle est fiable et qu'elle est peu coûteuse.

D'autres avantages et caractéristiques apparaîtront à l'aide de la description qui suit faite en regard des dessins annexés qui représentent :
- la figure 1, un exemple de signal à l'entrée d'un convertisseur analogique-numérique ;
- la figure 2, une fonction de transfert d'un circuit de limitation selon l'art antérieur,
- les figures 3, 4, 5, des dispositifs possibles selon l' invention
- la figure 6, une variante possible d'utilisation d'un dispositif selon l'invention;
- la figure 7, une application d'un dispositif selon l'invention dans une chaîne de réception d'un radar.

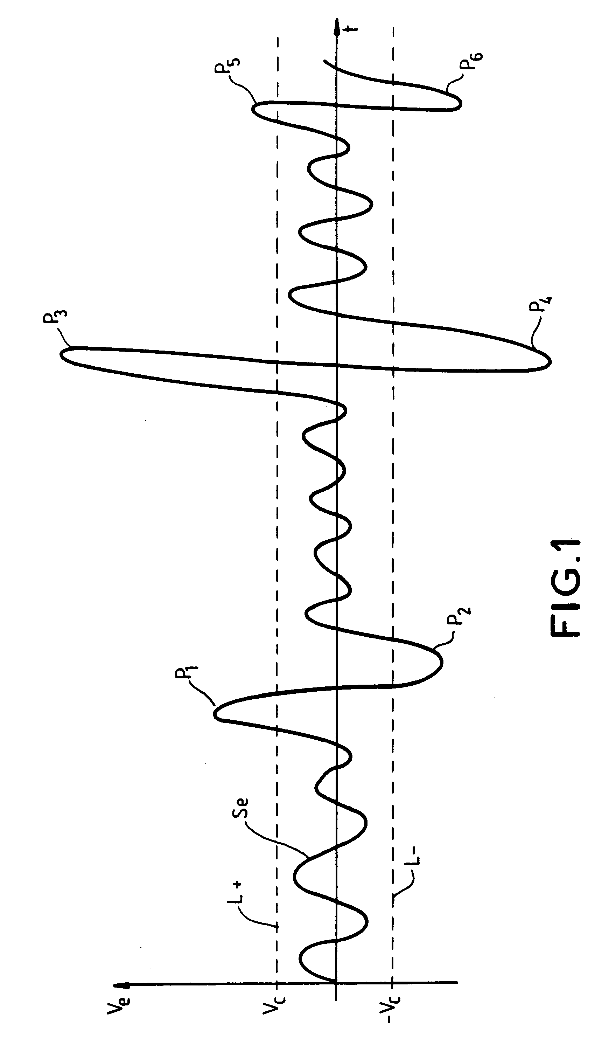

La figure 1 montre une courbe représentative d'un signal Se entrant par exemple dans un convertisseur analogique-numérique et ayant une tension Ve fonction du temps t. Ce signal peut être par exemple celui reçu par une chaîne de réception radar. Le convertisseur possède par exemple une plage de conversion délimitée par des tension Vc et -Vc, cette plage de conversion pourrait tout aussi bien être délimitée entre O et Vc, Vc représentant une tension positive, comprise entre 5v et 12v par exemple. Une tension supérieure à Vc ou inférieure à -Vc à l'entrée d'un convertisseur analogique-numérique détruit généralement ce dernier. La plupart du temps, le signal Se de la figure 1 reste à l'intérieur de limites L+ et L- correspondant respectivement aux tensions Vc et -Vc délimitant la plage de conversion du convertisseur. Néanmoins, ce signal Se possède par exemple des pointes de tension intermittentes P₁, P₂, P₃, P₄, P₅, P₆ supérieures à Vc ou inférieures à Vc et de plus ou moins grande valeur absolue et donc susceptibles de détruire le convertisseur.

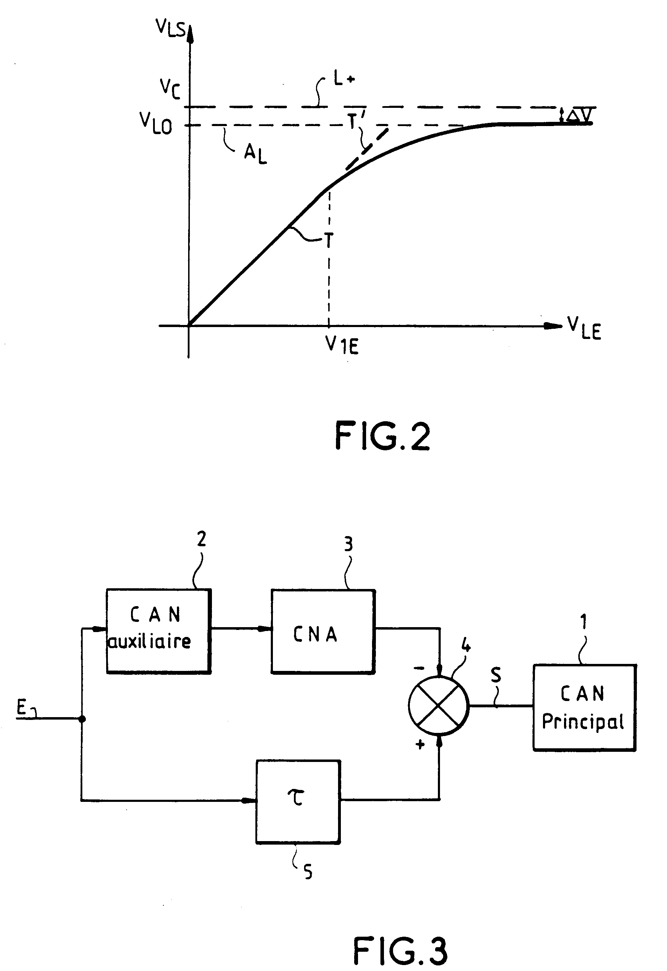

La figure 2 montre la fonction de transfert d'un circuit de limitation selon l'art antérieur. Cette fonction de transfert entre la tension d'entrée VLE et la tension de sortie VLS du circuit de limitation est représentée par la courbe T. Jusqu'à une tension V1E, la fonction de transfert T est sensiblement linéaire. Au-delà de cette tension V1E, cette fonction de transfert réelle T s'éloigne d'une fonction de transfert idéale T', linéaire. Les deux fonctions de transfert T, T' rejoignent une asymptote AL correspondant à la tension de limitation VLO du circuit. Cette tension VLO est nécessairement inférieure ou égale à la tension Vc du convertisseur analogique-numérique. Pour des raisons de réglage et surtout de dérive de cette tension de limitation VLO en fonction des conditions climatiques et en fonction du temps, cette tension VLO est calée en dessous de Vc, ou en dessus de -Vc avec un écart de tension AV non négligeable pour compenser notamment ces dérives. Outre la dégradation de la linéarité de la fonction de transfert des circuits de limitation, et donc l'erreur de conversion induite sur les signaux forts, supérieurs à V1E, cet écart ΔV ne permet pas de profiter pleinement de la plage de conversion du convertisseur analogique-numérique délimitée par la tension Vc.

La figure 3 propose un premier exemple de dispositif de limitation, selon l'invention, d'un signal d'entrée d'un convertisseur 1.

L'entrée du dispositif E est reliée à l'entrée d'un convertisseur auxiliaire analogique-numérique 2, comportant par exemple peu de bits de conversion et ayant une plage délimitée par au moins une tension V'c supérieure à Vc et aux tensions des signaux d'entrée.

Cette plage peut être prolongée pour les signaux négatifs, sa limite inférieure étant alors définie par exemple par -Vc'. Le convertisseur auxiliaire 2 peut être réalisé par exemple à partir d'éléments discrets selon des moyens connus de l'homme du métier, et posséder quelques bits de conversion ; 2, 3 ou 4 par exemple. Si les signaux à convertir sont positifs et négatifs, il peut fonctionner en complément à 2 pour tenir compte du signe des signaux. Il code par exemple les tensions multiples, positives ou négatives, de la tension Vc définissant la plage de conversion du convertisseur principal 1. Ainsi, si la tension à l'entrée est égale à 3Vc + ΔV, ΔV étant inférieure à Vc, le convertisseur auxiliaire 2 affiche à sa sortie la valeur numérique 3. En d'autres termes, le bit de poids faible du convertisseur auxiliaire 2, noté LSB, code la valeur Vc. Cependant, ce bit de poids faible LSB pourrait coder une valeur différente de Vc.

Le convertisseur auxiliaire 2 est relié à sa sortie à l'entrée d'un convertisseur numérique-analogique 3 ayant par exemple le même nombre de bits que le convertisseur auxiliaire analogique-numérique 2 ainsi que le même facteur d'échelle, c'est-à-dire qu'un bit de poids faible, noté LSB, du convertisseur numérique-analogique correspond au codage d'une tension de sortie sensiblement égale à Vc. Sa sortie est donc sensiblement égale à des multiples de la tension Vc délimitant la plage de conversion du convertisseur principal 1. La sortie du convertisseur numérique-analogique 3 est reliée à une entrée d'un circuit soustracteur 4, l'entrée négative par exemple. L'autre entrée de ce circuit soustracteur 4, l'entrée positive par exemple, est reliée à la sortie d'un circuit à retard 5 dont l'entrée est reliée à l'entrée E du dispositif et à l'entrée du convertisseur auxiliaire analogique-numérique 2. Le temps de retard τ apporté par le circuit à retard 5 est au moins égal aux temps de conversion cumulés du convertisseur auxiliaire 2 et du convertisseur numérique-analogique 3. Le circuit soustracteur 4 présente à sa sortie une tension égale à la tension arrivant sur son entrée positive, donc égale à la tension d'entrée du dispositif selon l'invention, retardée de τ, diminuée de la tension arrivant à son entrée négative, c'est-à-dire celle sortant du convertisseur numérique-analogique 3, multiple de la tension Vc. La sortie S du circuit soustracteur 4 constitue la sortie du dispositif selon l'invention, cette sortie S est câblée à l'entrée du convertisseur analogique-numérique principal 1 dont il est nécessaire de limiter le signal d'entrée.

Tous les signaux dont l'amplitude est inférieure à Vc provoquent un code égal à O en sortie du convertisseur auxiliaire 2 donc une tension nulle à l'entrée négative du circuit soustracteur 4. La sortie S du dispositif selon l'invention reproduit alors à l'entrée du convertisseur principal 1 le signal présent à son entrée E. Le dispositif est dans ce cas transparent. Si la tension présente à l'entrée E du dispositif est égale par exemple à 2^{q}xVc + ΔV, ΔV étant inférieure à Vc et q étant inférieur au nombre de bits du convertisseur auxiliaire 2, alors la sortie de ce dernier affiche 2^{q}. En conséquence, la sortie du convertisseur numérique-analogique 3 présente une sortie égale à 2^{q}xVc. Cette dernière tension est retranchée, par l'intermédiaire du circuit soustracteur 4, au signal d'entrée. Il ne reste plus alors à l'entrée du convertisseur principal qu'un signal d'amplitude ΔV, inférieure à la tension Vc. Les signaux présents à l'entrée du dispositif selon l'invention peuvent être positifs ou négatifs puisque le convertisseur auxiliaire 2 et le convertisseur numérique-analogique 3 peuvent fonctionner en complément à 2. Le convertisseur analogique-numérique principal 1 peut alors fonctionner suivant un code binaire naturel, sans indication de signe.

Pour indiquer aux circuits de traitement que le signal d'entrée du convertisseur principal est limité, un drapeau, constitué par exemple d'une combinaison des bits du convertisseur auxiliaire 2, se positionne à un niveau logique convenu lorsque par exemple l'un au moins de ces bits passe à 1, le passage du bit de poids faible à 1 indiquant par exemple une limitation d'un signal dont la tension passe au dessus de Vc et le passage de tous les bits à 1 indiquant par exemple une limitation d'un signal dont la tension passe en dessous de -Vc.

Le dispositif de limitation selon l'invention possède une linéarité sur toute la plage de conversion du convertisseur analogique-numérique principal 1, notamment au niveau des signaux de forte amplitude intérieurs à la plage de conversion, évitant ainsi les erreurs de conversion et permettant de profiter de la pleine plage de conversion du convertisseur principal 1. Cette linéarité est en fait celle du convertisseur analogique-numérique auxiliaire 2, du convertisseur numérique-analogique 3 et du soustracteur 4 sur cette plage de conversion.

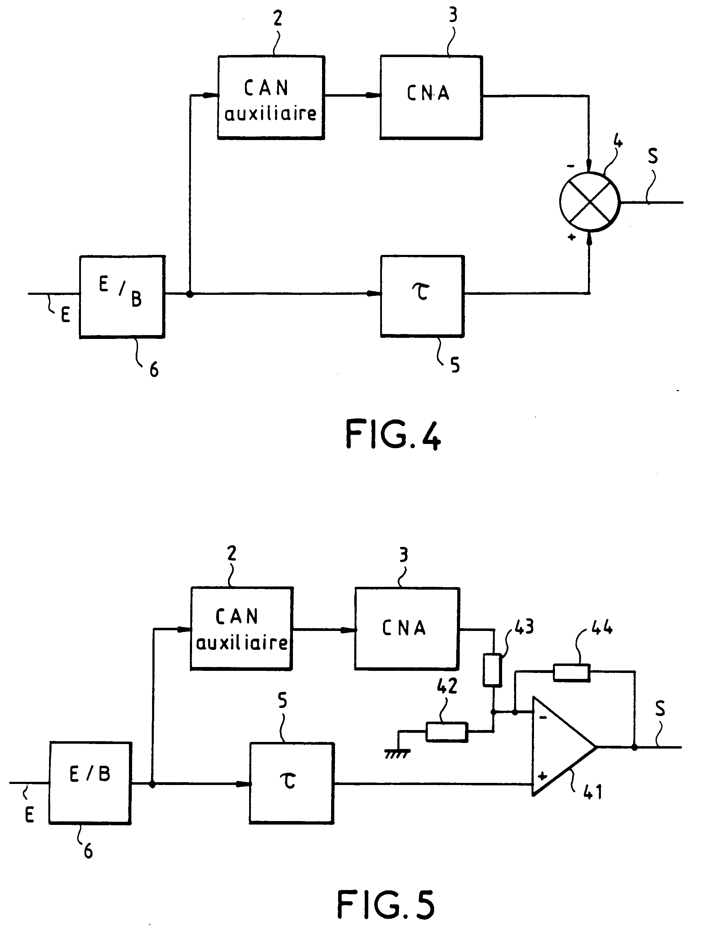

La figure 4 montre un dispositif possible selon l'invention très proche du précédent où un échantillonneur-bloqueur 6 a été rajouté en entrée, la sortie de ce dernier étant reliée aux entrées du convertisseur auxiliaire 2 et au circuit à retard 5. L'échantillonneur-bloqueur 6 permet par exemple de s'affranchir de variations brusques de signaux à l'entrée E du dispositif.

Le dispositif de la figure 5 reprend le dispositif de la figure 4 en explicitant un mode de réalisation possible du circuit soustracteur 4. Celui-ci peut être constitué par exemple d'un amplificateur opérationnel 41 et de trois résistances 42, 43, 44. L'entrée positive de l'amplificateur opérationnel 41 constituant l'entrée positive du circuit soustracteur 4. L'entrée négative de l'amplificateur opérationnel 41 est relié à un des pôles de chacune des résistances 42, 43, 44, une résistance 42 ayant son autre pôle relié au potentiel de masse représentant le zéro électrique des circuits du dispositif, une résistance 43 ayant son autre pôle relié à la sortie du convertisseur numérique-analogique 3 et constituant l'entrée négative du circuit soustracteur 4, et une résistance 44 ayant son autre pôle relié à la sortie de l'amplificateur opérationnel 41 constituant la sortie du circuit soustracteur 4.

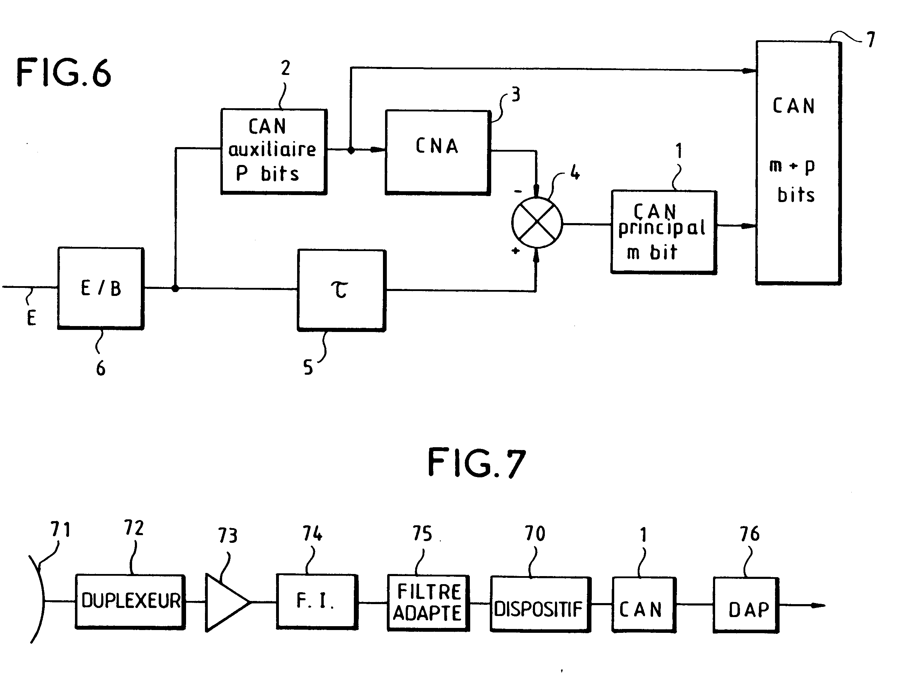

La figure 6 présente une variante possible d'utilisation du dispositif selon l'invention. Dans ce cas, les bits de sortie du convertisseur auxiliaire analogique-numérique 2 sont utilisés pour étendre la plage de conversion du convertisseur principal analogique-numérique 1. En effet, quel que soit le signal présent à l'entrée du dispositif selon l'invention, dans les limites de la plage de conversion du convertisseur auxiliaire, ce dernier code la partie de la tension multiple de Vc, Vc ayant été précédemment définie comme étant la tension maximum, limite de la plage de conversion du convertisseur principal 1, et ce dernier code la partie s'ajoutant à la tension codée par le convertisseur auxiliaire 2 et d'amplitude inférieure à Vc. Par exemple, un signal présent à l'entrée E du dispositif selon l'invention ayant une tension à convertir égale à 2^{q} Vc + ΔV provoque un code égal à 2^{q} en sortie du convertisseur auxiliaire 2, codé sur p bits, q étant inférieur ou égal à p. ΔV peut être codé par exemple sur n bits, par le convertisseur principal 1. Ainsi, à condition que les circuits de traitement puissent prendre en compte n+p bits, le dispositif selon l'invention associé au convertisseur principal 1, outre le fait qu'il limite les signaux présents à l'entrée de ce dernier, permet d'obtenir l'équivalent d'un convertisseur analogique-numérique 7 possédant n+p bits ayant une plage de conversion égale à celle du convertisseur auxiliaire 2, c'est-à-dire au moins égale à 2^{P} Vc.

Il étend en fait la plage de conversion du convertisseur analogique-numérique principal 1 à celle du convertisseur auxiliaire 2 en complétant vers les poids forts les bits de sortie du convertisseur principal 1 par les bits de sortie du convertisseur analogique-numérique auxiliaire 2. Des discontinuités apparaissant à des tensions multiples de la tension Vc et dues au codage du convertisseur auxiliaire peuvent entacher la conversion globale, néanmoins, pour certaines applications, ces discontinuités ne sont pas gênantes. Dans tous les cas d'applications, le dispositif selon l'invention limite la tension à l'entrée du convertisseur principal 1 dans sa propre plage de conversion.

La figure 7 présente une application possible du dispositif selon l'invention. Ce dernier, numéroté 70 est utilisé par exemple dans une chaîne de réception d'un radar. Une antenne 71 de réception est reliée à un duplexeur 72 dont la sortie est couplée à un amplificateur 73. La sortie de ce dernier est reliée à des circuits 74 de transposition du signal reçu en fréquences dites intermédiaires, de l'ordre de 60 MHz par exemple. La sortie de ces circuits 74 est reliée à l'entrée d'un filtre adapté 75. La sortie du filtre adapté 75 est reliée à l'entrée du dispositif 70 selon l'invention dont la tension de sortie est limitée par exemple à la plage de conversion du convertisseur analogique numérique 1 relié à la sortie du dispositif 70. La sortie du convertisseur analogique numérique 1 peut alors être relié à un discriminateur d'amplitude-phase numérique. Dans l'exemple d'application de la figure 7, le dispositif selon l'invention remplace des circuits de limitation classiques aux inconvénients précédemment mentionnés.

Le dispositif selon l'invention limite les signaux à l'entrée d'un convertisseur analogique-numérique, mais il peut tout aussi bien limiter les signaux à l'entrée d'autres circuits. La tension Vc étant alors la tension maximum admissible à l'entrée de ces circuits, cette tension constituant la tension de limitation du dispositif selon l'invention.

## Revendications

1. Dispositif de limitation de signaux d'entrée d'un convertisseur analogique-numérique (1) ayant une plage de conversion donnée (V_{c}), caractérisé en ce qu'il comprend au moins:
- un convertisseur analogique-numérique auxiliaire (2) ayant une plage de conversion (V'_{c}) supérieure à la plage de conversion donnée (V_{c}) du convertisseur (1);
- un convertisseur numérique-analogique (3) dont l'entrée est reliée à la sortie du convertisseur analogique-numérique auxiliaire (2);
- un circuit à retard (5) dont l'entrée est reliée à l'entrée du convertisseur analogique-numérique auxiliaire (2) et constitue l'entrée (E) du dispositif;
- un circuit soustracteur (4) présentant à sa sortie le signal arrivant sur une première entrée diminué du signal arrivant sur une deuxième entrée, la première entrée étant reliée à la sortie du circuit à retard (5) et la deuxième entrée étant reliée à la sortie du convertisseur numérique-analogique (3), la sortie du circuit soustracteur constituant la sortie (5) du dispositif.

2. Dispositif selon la revendication 1, caractérisé en ce que le convertisseur analogique-numérique auxiliaire (2) code des tensions multiples de la plage de conversion donnée (V_{c}) du convertisseur analogique-numérique, le bit de poids faible du convertisseur analogique-numérique auxiliaire (2) codant la valeur de la tension (V_{c}) délimitant la plage de conversion du convertisseur analogique-numérique (1).

3. Dispositif selon l'une quelconque des revendications précédentes, caractérisé en ce que le convertisseur numérique-analogique (3) comporte le même nombre de bits que le convertisseur analogique-numérique auxiliaire (2).

4. Dispositif selon l'une quelconque des revendications précédentes, caractérisé en ce que le codage du convertisseur analogique-numérique auxiliaire (2) et du convertisseur numérique-analogique est un codage en complément à 2.

5. Dispositif selon l'une quelconque des revendications précédentes, caractérisé en ce que le retard (τ) induit par le circuit à retard (5) est au moins égal aux temps de conversion cumulés du convertisseur analogique-numérique auxiliaire (2) et du convertisseur numérique-analogique (3).

6. Dispositif selon l'une quelconque des revendications précédentes, caractérisé en ce qu'il comporte en entrée (E) un échantillonneur-bloqueur (6), la sortie de l'échantillonneur-bloqueur (6) étant reliée à l'entrée du convertisseur analogique-numérique auxiliaire. (2) et à l'entrée du circuit à retard (5).

7. Dispositif selon l'une quelconque des revendications précédentes, caractérisé en ce que le circuit soustracteur (4) comprend au moins un amplificateur opérationnel (41) et trois résistances (42, 43, 44), l'entrée positive de l'amplificateur opérationnel (41) constituant l'entrée positive du circuit soustracteur (4), l'entrée négative de l'amplificateur opérationnel (41) étant reliée à un des pôles de chacune des résistances (42, 43, 44), une résistance (42) ayant son autre pôle relié au potentiel de masse, une résistance (43) ayant son autre pôle relié à la sortie du convertisseur analogique-numérique (3) et constituant l'entrée négative du circuit soustracteur (4), et une résistance (44) ayant son autre pôle relié à la sortie de l'amplificateur opérationnel (41) et constituant la sortie du circuit soustracteur (4).

8. Dispositif selon l'une quelconque des revendications précédentes, caractérisé en ce qu'il étend en outre la plage de conversion du convertisseur analogique-numérique (1) à la plage de conversion du convertisseur analogique-numérique auxiliaire (2) en complétant vers les poids forts les bits de sortie du convertisseur analogique-numérique (1) par les bits de sortie du convertisseur analogique-numérique auxiliaire (2).

9. Dispositif selon l'une quelconque des revendications précédentes, caractérisé en ce que le signal d'entrée du convertisseur analogique-numérique (1) étant limité, un drapeau se positionne à un état convenu, le drapeau étant constitué d'une combinaison de bits du convertisseur auxiliaire (2).

10. Dispositif selon l'une quelconque des revendications précédentes, caractérisé en ce qu'il est utilisé à l'entrée d'un convertisseur analogique-numérique (1) dans une chaîne de réception d'un radar.
